# EUROPEAN PATENT APPLICATION

(11) **EP 2 031 947 A1**
(43) Date of publication of application: **04.03.2009**
(21) Application number: 08162574.1
(22) Date of filing: 19.08.2008
(51) Int. Cl.: H05K 5/06, H05K 5/02

(54) **Electronic assembly having housing with embedded conductor connecting electrical component**

(30) Priority: 30.08.2007 US 897316
(71) Applicant: Delphi Technologies, Inc., Troy, Michigan 48007 (US)
(72) Inventor: Hinze, Lee R., Allen, TX 75013 (US)
(74) Representative: Denton, Michael John

(57) **Abstract**

An electronic assembly includes a printed circuit board and an electrical component arranged within a housing. The component is mounted in a lower region of the housing, and the printed circuit board is supported over the component. The housing is formed of a electrically insulating material and includes embedded conductors connecting the component to the printed circuit board. Potting material is disposed on the printed circuit board within the housing. A fill hole may be provided in the board over the component to allow the potting material to flow onto the electrical component for mechanical stabilization.

## Description

### TECHNICAL FIELD

The invention relates to an electronic assembly comprising an electronic component and a printed circuit board (PCB) arranged within a housing. More particularly, this invention relates to such assembly wherein the PCB overlies the electrical component within the housing and is connected by a conductor embedded in the walls thereof.

### BACKGROUND OF INVENTION

It is known to provide an electronic assembly that includes a printed circuit board (PCB) enclosed within a housing. Electronic components, such as capacitors, are mounted onto the PCB. The space required for mounting the housing is in large part dependant upon the footprint of the housing, as defined by the length and the width, which in turn is dependant on the area of the PCB. Thus, it is desired to reduce the area of the PCB in order to reduce the footprint of the housing. However, significant area is required for mounting the components to the PCB. Thus, it would be advantageous to locate the components apart from the PCB in order to allow the size of the PCB to be reduced. Reducing the size of the PCB would also reduce the cost of the PCB, and thereby the cost of the electronic assembly.

Also, it has been proposed to mount components using solderless connections. A suitable solderless connection is formed by a terminal inserted in a hole in the lead from the component. In use, the electrical assembly may be subjected to mechanical forces which tend to dislodge the component, causing the lead to be withdrawn from the hole, thereby severing the electrical connection and causing circuit failure. It is desired to provide a robust assembly to stabilize the component within the housing, to prevent dislodgement of the terminal and provide a reliable connection.

### SUMMARY OF THE INVENTION

In accordance with this invention, an electronic assembly comprises a housing including a bottom wall and a sidewall which defines a compartment. The sidewall includes a board support spaced from the bottom wall. The compartment comprises a lower region between the board support and the bottom wall. The housing is formed of an electrically insulating material and comprises an embedded conductor. The embedded conductor has a first terminal adjacent to the bottom wall and a second terminal at the board support. The first terminal may be protruding from the bottom wall or the sidewall in the lower region. An electrical component is mounted to the housing within the lower region and has a lead connected to the first terminal A printed circuit board (PCB) is supported by the board support so that the PCB overlies the electrical component. The PCB comprises an electrical circuit and a board contact hole for receiving the second terminal, so that the second terminal is in electrically communication with the electrical circuit. Potting material overlies the PCB within the housing.

In one aspect of this invention, an electronic assembly comprises a housing defining a compartment having an upper region and a lower region. The housing includes a bottom wall and a sidewall. The sidewall includes a lower portion adjacent to the bottom wall, a lip spaced apart from the bottom wall, and a board support located between the lower portion and the lip and extending circumferentially about the compartment. The housing is formed of an electrically insulating material and comprises an embedded conductor having a first terminal protruding from the bottom wall and a second terminal protruding from the board support in a direction away from the bottom wall. An electrical component is mounted to the bottom wall and disposed within the lower region. The electrical component comprises an upper surface and a lead adjacent to the bottom wall of the housing. The lead defines a contact hole that receives the first terminal to form an electrical connection. A printed circuit board (PCB) is received in the compartment and is supported by the board support. The PCB and board support cooperate to form a seal suitable for containing a liquid potting material. The PCB comprises an electrical circuit and defines a board contact hole. The second terminal is received in the board contact hole and is in electrical communication with the electrical circuit. A fill hole in the PCB overlies the electrical component and allows the potting material disposed in the upper region of the compartment to extend through the fill hole and contact the upper surface of the electrical component. This potting material is formed of an electrically insulative polymeric material, and provides a structural spacer to prevent dislodgment of the electrical component toward the printed circuit board.

### BRIEF DESCRIPTION OF DRAWINGS

This invention will be further described with reference to the accompanying drawings in which:
Fig. 1 is a perspective view showing the electronic assembly in accordance with a preferred embodiment of this invention; and
Fig. 2 is a cross-section of the electronic assembly in Fig. 1 taken along line 2-2 in the direction of the arrows.

### DESCRIPTION OF THE PREFERRED EMBODIMENTS

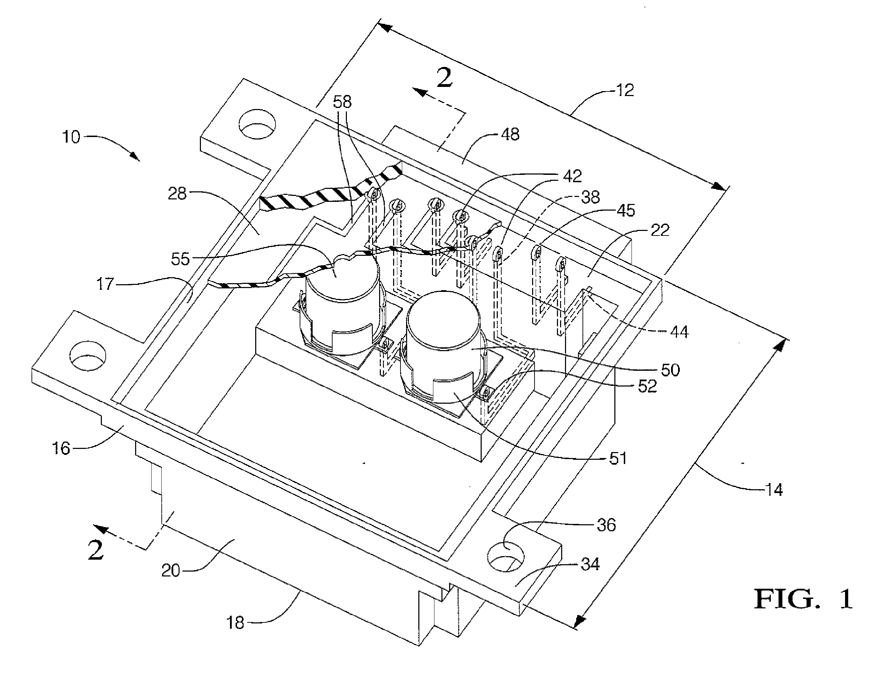

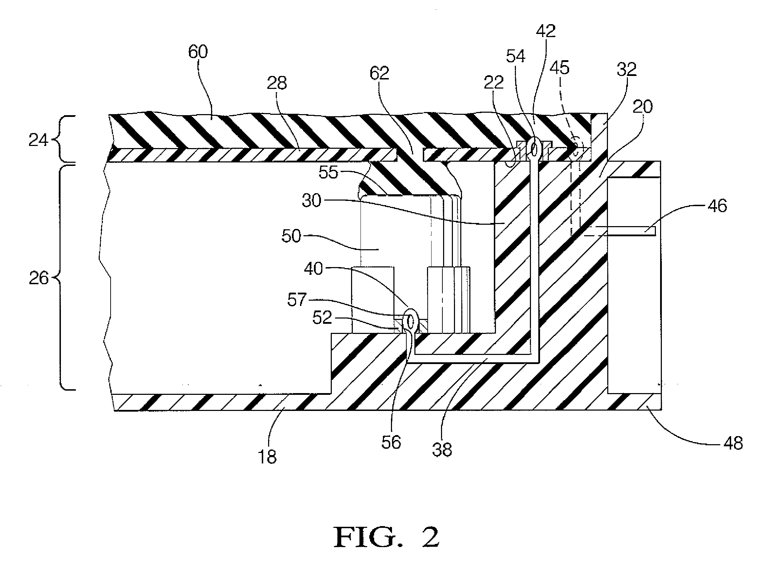

In accordance with a preferred embodiment of this invention, referring to Figs. 1 and 2, there is depicted an electronic assembly 10. Assembly 10 is preferably an Electronics Control Unit (ECU) for controlling deployment of air bag safety devices onboard an automotive vehicle. Alternately, the assembly may be used for other applications, depending on the electrical circuit and components. In use, the assembly is adapted to be mounted to a support structure. The space required for mounting the assembly is largely determined by the footprint, defined by the length indicated by arrow 12 and width indicated by arrow 14.

Assembly 10 includes a housing 16 defining a compartment 17. Housing 16 is generally cubic shaped, and includes a bottom wall 18 and sidewalls 20. Each sidewall 20 includes a board support 22 spaced apart from the bottom wall 18, dividing the compartment into an upper region 24 and a lower region 26. Board support 22 is adapted to mount a printed circuit board (PCB) 28 above the bottom wall 18, in parallel, spaced relationship. In a preferred embodiment, board support 22 is depicted as extending circumferentially about housing 16. Alternately, board support may be suitably located for stable support of the board, for example, on opposite sidewalls. Sidewall 20 also includes a lower portion 30 between bottom wall 18 and support 22 and a lip 32 extending above support 22 and surrounding the open top, such that support 22 is intermediate lower portion 30 and lip 32. In a preferred embodiment, lip 32 extends circumferentially about PCB 28 above board support 22 to contain a liquid potting material. Tabs 34 extend outwardly from lip 32, perpendicular to sidewalls 20, and planar with top surface of housing 16. Tabs 34 include holes 36 adapted to receive bolts for mounting housing 16 to a support structure (not shown).

Housing 16 is made of an electrically insulative polymeric material and contains conductors 38. Conductors 38 are embedded within the polymeric material during molding and are preferentially formed of metal. Alternatively, the conductors may be formed of electrically conductive polymer material to provide a suitable electrical connection between PCB 28 and an electrical component 50 mounted within lower region 26. Each conductor 38 includes a first terminal 40 adjacent bottom wall 18 and a second terminal 42 adjacent board support 22. In a preferred embodiment shown in the figures, electrical connections to the terminals are of the type referred as solderless connections and do not require a soldering operation to complete the electrical connection. Rather, the electrical connection is formed by inserting the terminal within a hole in the PCB or the component. An opening is provided in each terminal to provide compliance during insertion and assure suitable contact. It is a feature of the described embodiment that the terminals protrude from the surrounding surface in a direction away from the bottom wall and toward the open top. This facilitates formation of connections to the PCB or the component when received through the open top into housing 16. Alternatively, terminals in the compartment could protrude laterally, for example, from the sidewall 20 parallel to bottom wall 18. While in the depicted embodiment components are mounted to the bottom wall 18 to facilitate assembly, the components may be mounted to extend from the sidewall 20 in the lower region 26, and connect to conductors that extend from the sidewall. This embodiment may be advantageous to reduce the height of the lower region 26 of the compartment 17 and thereby the overall height of the assembly while accommodating tall components.

Housing 16 also includes a plurality of connector pins 44 for making external connections to a suitable connector socket. Each pin 44 is embedded in housing 16 and includes an inner terminal 45 adapted for solderless connection to PCB 28 in a manner similar to the first terminal and an outer terminal 46 adapted for connection to a socket (not shown). A shroud 48 formed of insulative polymeric material extends from sidewall 22 and encircles outer terminals 46 to provide mechanical protection.

Electrical components 50 are mounted to the bottom wall 18 of housing 16 and disposed within the lower region 26. In the depicted embodiment, component 50 is a capacitor. Alternately, the component may be an inductor or any other electrical component that needs electrical connection to a printed circuit board. Also, two components are depicted in the Figs. However, the assembly may include fewer or more components, or different components, as needed to perform the electrical function of the assembly. Component 50 includes a base 51 and a lead 52 that includes a contact hole 56. Component 50 is mounted to the housing by positioning the base adjacent bottom wall 18 and inserting terminals 40 into holes 56. In this manner, the terminals not only attach the component to the bottom wall, but also form an electrical connection to the component. This invention is particularly advantageous when used to remotely connect large components having a minimal number of leads, thereby reducing the area of the PCB. In the preferred embodiment, a solderless connection is formed between first terminal 40 and hole 56. Preferably, terminal 40 includes an eye 57 allowing compliance in the connection to ensure a robust electrical connection. Alternately, a solder connection may be formed between the terminal and the lead. An upper surface 55 of the component 50 underlies the PCB 28 and is spaced apart therefrom.

PCB 28 is received in the compartment and supported on support 22 spaced apart from the bottom wall and above the electrical component. PCB 28 engages the support about the entire perimeter of the housing to form a seal to contain liquid that solidifies to form the potting material. In this manner, the PCB and lip cooperate to contain the liquid potting material in the upper region and prevent the liquid from filling the lower region. PCB 28 includes board contact holes 54 that receive second terminals 42 of the embedded conductors, thereby providing electrical communication between the terminals and an electrical circuit 58 on the board adjacent holes 54. In the preferred embodiment, second terminals 42 are received in holes 54 to make solderless connections. Similar electrical connections are made between terminals 45 of pin conductors 46 and the circuit on the PCB. Alternately, the PCB and the terminals may be connected using solder connections.

PCB 28 also includes a fill hole 62 overlying and spaced apart from upper surface 55 of the electrical component 50. An electrically insulative polymeric potting material 60 is dispensed on the surface of the PCB 28 facing the top of the housing. Potting material 60 is disposed in the upper region of the compartment, overlying the PCB and then bonds to lip 32 securing the PCB against the support 22. Potting material 60 covers the PCB 28 and protects the circuit 58 and components mounted to the PCB from mechanical damage. Potting material 60 extends through fill hole 62 in PCB 28 and onto the upper surface 55 of component 50. In this manner, the potting material forms a spacer between the top of electrical component 50 and the bottom surface of the PCB, to prevent dislodgment of electrical component 50 toward PCB 28.

The manufacture of assembly 10 will now be described. Housing 16 is formed by injection molding an insulative polymeric material within a mold having the desired size and shape of the housing. Conductors 38 and pin conductors 44 are formed of metal and arranged in the mold cavity prior to the molding operations, becoming embedded within the polymer. First terminals 40 and second terminals 42 are received in holes in the mold and so not embedded within the polymeric material during molding. Terminals 40 and 42 include an eye structure 57 to enable a pressed fit, solderless connection to electrical component 50 and PCB 28, respectively.

Components 50 are assembled into compartment 17 through the open top and mounted to the bottom wall by pressing the component holder 51 over the compliant pins. Terminals 40 are press fit within contact holes 56 to form the desired electrical connections. PCB 28 is mounted through the open top onto support 22, with terminals 42 received in holes 54 to form the desired solderless electrical connections. Liquid potting material is poured into the upper region of the housing over PCB 28 and, upon solidification, forms a layer 60 securing PCB 28 against support 22 and protecting the circuit and components mounted thereon. The liquid potting material flows through fill holes 62 and onto upper surfaces 55 of components 50. Upon solidification, the potting material secures the components in position. Potting material 60 on top surface of PCB 28 seals housing 16. Housing 28 is suitably mounted to a support structure using bolts (not shown) passing through holes 36 in tabs 34.

Thus, this invention provides an electronic assembly including a PCB and electrical components arranged within a housing. The components are located under the PCB to reduce the footprint of the electronic assembly, thereby allowing the assembly to be mounted onto a support structure in locations where less space is available for the mounting. Furthermore, the ease of manufacture of the electronic assembly in the present invention leads to increased yield during the manufacturing process. Placement of parts for the entire electronic assembly is through the top of the housing to facilitate manufacture. Press fitted solderless connections between the electrical components, PCB, and external terminals eliminate a solder step in the manufacture of the electronic assembly. Sealing of the housing with potting material further protects the components located on the PCB and holds the PCB in place. Potting material that passes through the fill hole in the PCB creates a spacer between the bottom of the PCB and the top of the electrical component, providing increased mechanical stability of the mounted electrical component. Thus, reliability of the solder connections is enhanced by using the potting material to secure the PCB and components in place.

While this invention has been described in terms of the preferred embodiments thereof, it is not intended to be so limited, but rather only to the extent set forth in the claims that follow.

## Claims

1. An electronic assembly comprising:
a housing comprising a bottom wall and a sidewall and defining a compartment, said sidewall comprising a board support spaced apart from the bottom wall, said compartment comprising a lower region between the bottom wall and the board support, said housing being formed of an electrically insulating material and comprising an embedded conductor having a first terminal adjacent to said bottom wall and a second terminal proximate said board support,
an electrical component mounted to the housing within the lower region and having a lead connected to the first terminal;
a printed circuit board supported by said board support such that the printed circuit board overlies the electrical component, said printed circuit board comprising an electrical circuit and defining a board contact hole receiving the second terminal such that the second terminal is in electrical communication with the electrical circuit; and
a potting material disposed within the housing overlying the printed circuit board.

2. An electronic assembly in accordance with claim 1, wherein said electrical component has an upper surface facing toward the printed circuit board, and wherein said printed circuit board further comprises a fill hole overlying said electrical component, and wherein the potting material extends through the fill hole onto the upper surface of said electrical component.

3. An electronic assembly according to claim 1, wherein said board support is a strip extending circumferentially about the compartment.

4. An electronic assembly according to claim 1, wherein the sidewall includes a lip extending above the board support, said lip cooperating with the printed circuit board to define a region containing the potting material.

5. An electronic assembly according to claim 1, wherein the electrical component is a capacitor.

6. An electronic assembly according to claim 1, wherein the housing includes a connector portion comprising a plurality of connector pins extending through the sidewall, each said connector pin having an inner terminal connected to the printed circuit board and an outer terminal adapted for external connection, said housing further comprising a shield extending from the sidewall about the outer terminals.

7. An electronic assembly comprising:
a housing defining a compartment having an upper region and a lower region, said housing comprising a bottom wall and a sidewall, said sidewall comprising a lower portion adjacent the bottom wall, a lip spaced apart from the bottom wall, and a board support disposed between the lower portion and the lip and extending circumferentially about the compartment, said housing being formed of an electrically insulating material and comprising an embedded conductor having a first terminal protruding from the bottom wall and a second terminal protruding from said board support in a direction away from the bottom wall,
an electrical component mounted to the bottom wall and disposed within the lower region, said electrical component comprising an upper surface and a lead adjacent the bottom wall of the housing and defining a component contact hole, said first terminal being received within the component contact hole for forming an electrical connection there; and
a printed circuit board received in the compartment and supported by said board support, said printed circuit board and said board support cooperating to from a seal suitable for containing a liquid potting material, said printed circuit board comprising an electrical circuit and defining a board contact hole and a fill hole, said second terminal being received in the board contact hole in electrical communication with the electrical circuit, said fill hole overlying the electrical component; and
potting material disposed with the upper region of the compartment and extending through the fill hole and in contact with the upper surface of the electrical component, said potting material being formed of an electrically nonconductive polymeric material and providing a spacer to prevent dislodgment of the electrical component toward the printed circuit board.
